# EUROPEAN PATENT APPLICATION

(11) **EP 3 926 700 A1**
(43) Date of publication of application: **22.12.2021**
(21) Application number: 20756386.7
(22) Date of filing: 13.02.2020
(51) Int. Cl.: H01L 51/50, H01L 51/56, H01L 51/52

(54) **OLED DEVICE AND MANUFACTURING METHOD THEREFOR**

(30) Priority: 14.02.2019 CN 201910113418
(71) Applicant: Gu'an Yeolight Technology Co., Ltd., Langfang, Hebei 065500 (CN)
(72) Inventor: LU, Tianxing, Langfang, Hebei 065500 (CN); WU, Haiyan, Langfang, Hebei 065500 (CN); XU, Xianbin, Langfang, Hebei 065500 (CN); ZHU, Yingguang, Langfang, Hebei 065500 (CN); XIE, Jing, Langfang, Hebei 065500 (CN); ZHANG, Guohui, Langfang, Hebei 065500 (CN); HU, Yonglan, Langfang, Hebei 065500 (CN)
(74) Representative: HGF
(86) International application number: PCT/CN2020/075133
(87) International publication number: WO 2020/164554

(57) **Abstract**

Provided are an organic light-emitting diode, OLED, device and a manufacturing method therefor. The OLED device includes a substrate and an encapsulation layer. The substrate is divided into a pixel region and an encapsulation region. The substrate and the encapsulation layer are connected by means of a sealing medium. A first electrode layer, an organic light-emitting layer and a second electrode layer are stacked at the pixel region on the substrate, and a buffer layer is provided between the first electrode layer and the substrate. In the present disclosure, the buffer layer is provided so that the problem of side etching occurring in dry etching of an auxiliary electrode is solved, and metal ions of a glass substrate are blocked from penetrating into the first electrode layer/auxiliary electrode, thereby avoiding the occurrence of electrochemical corrosion; the auxiliary electrode is added so that the luminance uniformity of a panel is improved; moreover, a pixel defining layer is provided on the first electrode layer and the auxiliary electrode and is in direct contact with the buffer layer, and the material of the pixel defining layer and the material of the buffer layer are each an inorganic compound, which forms a structure well surrounding an effective pixel region and/or pixels of an OLED, thereby avoiding the release of volatile gas (outgassing) into the interior of the pixel to cause pixel shrinkage, and improving the reliability of the OLED panel.

## Description

### TECHNICAL FIELD

The present disclosure relates to the technical field of organic light-emitting diode (OLED) devices and in particular to an OLED device and a manufacturing method therefor.

### BACKGROUND

Organic electroluminescent devices (OLED devices) have more advantages than other lighting methods (such as candles, halogen lamps and LED lamps), for example, have no ultraviolet, no infrared radiation, soft light, no glare, no flicker, rich spectrum and high color rendering quality, and can be used for general lighting, automotive lighting and display fields. Currently, a major bottleneck for OLED devices is the service life.

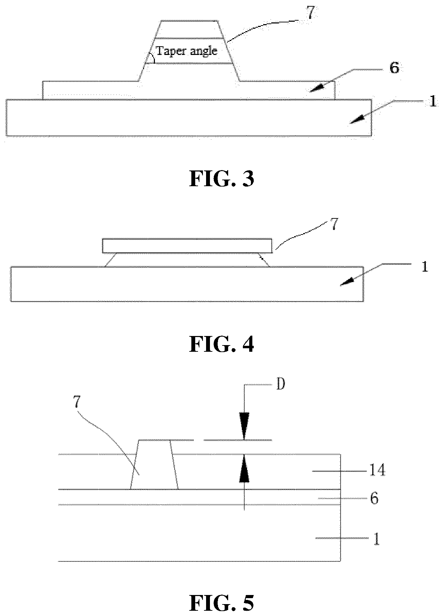

The traditional OLED device structure includes a substrate, an anode, an insulating layer, organic functional layers, a cathode, and an encapsulation structure. The substrate is usually an alkali-free glass (Glass). The anode is usually a transparent conductive oxide (such as indium tin oxide (ITO) and aluminum doped zinc oxide (AZO)). The insulating layer is generally photolithographic resin, such as phenolic resin or polymethyl methyl acrylate. The organic functional layers may include a hole injection layer (HIL), a hole transport layer (HTL), a light-emitting layer (EML), an electron transport layer (ETL), an electron injection layer (EIL), etc. The encapsulation layer may be a glass encapsulation cover and is adhered to the substrate through ultraviolet (UV) glue to protect the organic functional layers. The traditional device structure includes the following disadvantages:
(1) Since the substrate is in direct contact with the anode, certain ions in the substrate (such as potassium ions and calcium ions) will penetrate into the anode and cause electrochemical corrosion, which will affect the work function of the anode, increase the power consumption of the OLED, and lead to reduce the service life of the OLED;
(2) The photolithography resin as the insulating layer is usually an organic resin. The resin may outgas harmful gases, such as water, carbon dioxide, and sulfur compounds when the OLED is lit for a long time. The harmful gases further chemically react with the organic functional layers, which affects the performance of organic functional layers and the service life of the OLED;
(3) Generally, a large-area OLED device has uneven brightness, and the brightness uniformity can be improved by adding the auxiliary electrode (such as molybdenum aluminum molybdenum). However, the dry etching method that the industry adopts is easy to cause the undercut problem as shown in in FIG. 4 during the dry etching process. The main reason is that the "side etching" happens in the vertical etching process on the substrate side during the dry etching process. The "undercut" is not expected, because the "undercut" will cause discontinuity and fracture of the subsequent OLED film layers, which will lead to encapsulation failure and abnormal lighting, thereby affecting the service life of the device;
(4) Particles are inevitably introduced during the OLED manufacturing process. Because of the relatively thin device film layer (< 500 nm), the introduction of particles may cause the anode and the cathode of the device to be in contact with each other and form a short-circuit point. The current flows through the short-circuit point to form a black spot, causing the entire panel to fail after the black spot further expands.
(5) The OLED organic materials are easily corroded by water and oxygen. Thin film encapsulation is a good manner. A layer of inorganic material is generally formed by the plasma-enhanced chemical vapor deposition (PECVD) method and for example, is silicon oxide, silicon nitride or silicon oxynitride. Great stress is usually provided in the manner of thin film encapsulation. When the stress is released, the thin film can be wrinkled or broken, which affects the effect of thin film encapsulation, further leads to water and oxygen erosion, and finally affects the service life of the OLED device.

### SUMMARY

Therefore, the present disclosure aims to solve the problem of poor service life and failure of a device caused by materials or structures in the existing art. For this reason, the present disclosure provides an OLED device and a manufacturing method therefor. A buffer layer is added on the substrate so that the metal ions in the glass can be prevented from penetrating into the device. At the same time, the added buffer layer can improve the dry etching undercut problem of the auxiliary electrode on the buffer layer to form a taper angle of 20° to 80° of the auxiliary electrode, which improves the encapsulation service life of the device. In addition, the inorganic compounds are selected as the pixel defining layer so that the volatile gas can be prevented from being released (outgassed) into the pixel, and thus the pixel is prevented from shrink, which improves the reliability of the OLED panel. Furthermore, the pixel defining layer provided on the first electrode layer and the auxiliary electrode is in direct contact with the buffer layer, forming a good surrounding structure for the effective pixel region and/or the pixel of the OLED, and reducing the erosion of the pixel region caused by particles or gases introduced during the process. At the same time, the pixel defining layer and/or the buffer layer located at the encapsulation region are patterned. The encapsulation layer on the OLED materials is in direct contact with the patterned pixel defining layer and/or buffer layer to further form a good stress relief structure, increasing the interface encapsulation effect. The intrusion of water and oxygen is reduced, and the encapsulation reliability is improved.

In order to achieve the above object, the present disclosure adopts the technical solutions described below.

An OLED device is provided and includes a substrate and an encapsulation layer, where the substrate and the encapsulation layer form a hermetic space in which a first electrode layer, serval auxiliary electrodes arranged at intervals and a pixel defining layer are arranged.

A buffer layer is provided between the first electrode layer/the serval auxiliary electrodes and a substrate the buffer layer is provided with the serval auxiliary electrodes, the first electrode layer covers the buffer layer and the serval auxiliary electrodes, the pixel defining layer completely covers the first electrode layer on the auxiliary electrode and is patterned with an aperture which exposes at least a part of the first electrode layer, and the pixel defining layer and the aperture are sequentially covered with an organic light emitting layer and a second electrode layer.

The substrate is divided with serval pixel regions distributed in an array and an encapsulation region surrounding all the pixel regions, an edge position of each of the serval pixel regions is surrounded by the pixel defining layer, and the serval auxiliary electrodes are distributed in at least one of a horizontal position or a vertical position of the pixel regions distributed in the array.

The first electrode layer and the serval auxiliary electrodes at the encapsulation region are removed by etching process so that the buffer layer is in direct contact with the pixel defining layer.

A continuous patterned structure is formed on the buffer layer located at the encapsulation region, and the encapsulation layer is in direct contact with the patterned structure of the buffer layer.

The patterned structure is at least one of serval groove structures or serval dam structures patterned on the buffer layer.

The first electrode layer located on one or two sides of each of the serval auxiliary electrodes is removed by etching process so that the pixel defining layer located in the one or two sides of the each of the serval auxiliary electrodes is in direct contact with the buffer layer.

A width of a region at which the first electrode layer located on one or two sides of the each of the serval auxiliary electrodes is in direct contact with the buffer layer is 1 µm to 1 cm.

The first electrode layer between two adjacent pixel regions distributed in the array is patterned with a short-circuit prevention structure layer in a direction perpendicular to the serval auxiliary electrodes, and the short-circuit prevention structure layer is electrically connected to the first electrode layer on the each of the serval auxiliary electrodes and one of the two adjacent pixel regions and forms a disconnect with another one of the two adjacent pixel regions; and the pixel defining layer located on two sides of the short-circuit prevention structure layer is in direct contact with the buffer layer.

A width of a region at which the pixel defining layer is in direct contact with the buffer layer located on one or two sides of the each of the serval auxiliary electrodes is 5 µm to 10 mm.

A combination is one or more of titanium (Ti), aluminum (Al), molybdenum (Mo), or copper (Cu).

A taper angle of the each of the serval auxiliary electrodes is 10° to 90°.

An etching selection ratio of a material with a low etching rate of each of the serval auxiliary electrodes to a material of the buffer layer is (0.5-20); and the etching selection ratio of a material of the pixel defining layer to the material of the buffer layer is (0.5-5).

Furthermore and preferably, etching selection ratio of the material of each of the serval auxiliary electrodes to the material of the buffer layer is (5-7).

A thickness of the buffer layer is 10 nm to 3 µm.

A planarized auxiliary buffer layer is also provided on the buffer layer located between the serval auxiliary electrodes, and the each of the serval auxiliary electrodes is higher than the auxiliary buffer layer by 0 µm to 1 µm.

The pixel defining layer, the buffer layer and the encapsulation layer are made of same materials or different materials which are a combination of one or more of silicon nitride, silicon oxide, or silicon oxynitride.

The encapsulation layer has a thin film encapsulation structure, a cover plate is further provided on the encapsulation layer, and the cover plate is combined with the encapsulation layer through an encapsulation transition layer.

Alternatively, the encapsulation layer is an encapsulation cover, and the encapsulation cover is combined with the buffer layer of an encapsulation region on the substrate by a UV glue.

Meanwhile, the present disclosure also provides a manufacturing method of an OLED device. The method includes the steps described below.

In S1, a substrate is divided into a pixel region and an encapsulation region surrounding the pixel region, and a buffer layer is deposited on the substrate, where an auxiliary electrode layer is manufactured on the buffer layer which is etched to form serval auxiliary electrodes arranged at intervals, and a taper angle of each of the serval auxiliary electrodes is 10° to 90°.

In S2, a first electrode layer is manufactured on a basis of step S1, where the first electrode layer covers the buffer layer and the auxiliary electrode, and the first electrode layer located between the auxiliary electrode and the encapsulation region is removed by etching process in order to expose the buffer layer.

In S3, a pixel defining layer is deposited on a basis of step S2, where the pixel defining layer covers the first electrode layer and the buffer layer, and the pixel defining layer is etched to form an aperture, where a bottom of the aperture is the first electrode layer and the buffer layer.

In S4, an organic light-emitting layer and a second electrode layer are made by an evaporation method on a basis of step S3, where the organic light-emitting layer and the second electrode layer are sequentially formed on the pixel defining layer and in the aperture.

In S5, an encapsulation layer is made on a basis of step S4, where the encapsulation layer covers the entire pixel region, and the encapsulation region surrounding the pixel region seals and protects the entire pixel region.

The step S2 is as follows: the first electrode layer is manufactured on the basis of the step S1, where the first electrode layer covers the buffer layer and the serval auxiliary electrodes, the first electrode layer located on one or two sides of each of the serval auxiliary electrodes is removed by etching process so as to expose the buffer layer, and etching is performed to form a short-circuit prevention structure layer.

The buffer layer located at the encapsulation region is formed with at least one of serval patterned groove structures or serval dam structures in the step S3, and the encapsulation layer is in direct contact with at least one of the serval patterned groove structures or the serval dam structures on the buffer layer in an encapsulating process of step S5.

The present disclosure has the beneficial effects described below compared with the existing art.
(1) In the present disclosure, a buffer layer is added on the glass substrate, which can prevent the metal ions of the glass substrate from penetrating into the first electrode layer/auxiliary electrode, avoiding the occurrence of electrochemical corrosion and improving the stability of the OLED device.
(2) With the added buffer layer structure, side etching of the auxiliary electrode can be avoided during the dry etching or etching process, thereby effectively solving the "undercut" phenomenon for the auxiliary electrode. The continuity of the subsequent organic/metal/encapsulation film layer is improved, thereby increasing the reliability of the encapsulation and the service life of the OLED device.
(3) The present disclosure introduces a short-circuit prevention structure through the patterning of the first electrode, which can prevent the device from failure due to the short circuit of the device during the long-term aging (such as long-term lighting).
(4) In the present disclosure, inorganic compounds (such as silicon oxide, silicon nitride and silicon oxynitride) are selected as the pixel defining layer to prevent the volatile gas which can cause pixel shrinkage from being released (outgassed) into the pixel, improving the reliability of the OLED panel. In addition, the pixel defining layer provided on the first electrode layer and the auxiliary electrode is in direct contact with the buffer layer, which can form a good surrounding structure for the effective pixel region and/or pixel of the OLED and reduce the corrosion impact of particles or gases introduced to the pixel region during the process, and then improve the service life of the panel.
(5) In the OLED device provided by the present disclosure, the buffer layer in the encapsulation region is patterned with a groove structure and/or a dam structure is arranged on the buffer layer. The encapsulation layer is in direct contact with the patterned groove structure and/or the dam structure, further forming a good stress relief structure and increasing the interface bonding encapsulation effect, reducing the intrusion of water and oxygen and improving the encapsulation reliability and the service life of the panel.
(6) As a special structure of the present disclosure, a silicon nitride (or silicon oxide) structure auxiliary buffer layer is also added on the buffer layer 6 between the auxiliary electrodes. The auxiliary buffer layer structure is fabricated and planarized through the methods such as dry etching, grinding and lift-off. The auxiliary electrode is higher than the auxiliary buffer layer by the height D of 0 µm to 1 µm. This makes the subsequent first electrode layer more planar, which helps to improve the uniformity of the overlap resistance (the contact resistance between the auxiliary electrode and the first electrode).

### BRIEF DESCRIPTION OF DRAWINGS

In order to more clearly illustrate the embodiments of the present disclosure or the technical solutions in the existing art, the drawings that need to be used in the embodiments or the description of the existing art are described below. Apparently, the drawings in the following description are some embodiments of the present disclosure. For those of ordinary skill in the field, other drawings can be obtained based on these drawings without creative work.
FIG. 1 is a schematic diagram of an OLED device of the present disclosure;
FIG. 2 is a cross-sectional view of A-A' in FIG. 1;
FIG. 3 is a schematic diagram of an auxiliary electrode structure of the present disclosure;
FIG. 4 is a schematic diagram of an auxiliary electrode structure in the existing art;
FIG. 5 is a schematic diagram of an auxiliary buffer layer structure provided on a buffer layer;
FIG. 6 is a top view of a pixel defining layer after manufacturing of the pixel defining layer is completed;
FIG. 7 is a cross-sectional view of C-C' in FIG. 6;
FIG. 8 is a cross-sectional view of D-D' in FIG. 6;
FIG. 9 is a partial enlarged view of FIG. 8;
FIG. 10 is a schematic diagram of a structure with a cover plate according to the present disclosure;
FIG. 11 is a schematic diagram of a first partial structure shown in FIG. 10;
FIG. 12 is a schematic diagram of a second partial structure shown in FIG. 10;
FIG. 13 is a schematic diagram of a third partial structure shown in FIG. 10; and
FIG. 14 is a schematic diagram of a fourth partial structure shown in FIG. 10.

### Reference numerals:

1-substrate, 2-first electrode layer, 3-organic light-emitting layer, 4-second electrode layer, 5-cover plate, 6-buffer layer, 7-auxiliary electrode, 8-UV glue, 9-encapsulation region, 10-encapsulation layer, 11-pixel region, 12-pixel defining layer, 13-short-circuit prevention structure layer, 14-auxiliary buffer layer, 15-dam structure, 16-groove structure, 17- aperture; 18-encapsulation transition layer.

### DETAILED DESCRIPTION

The technical solutions of the present disclosure will be clearly and completely described below in conjunction with the drawings. Apparently, the described embodiments are part, not all, of the embodiments of the present disclosure. Based on the embodiments of the present disclosure, all other embodiments obtained by those of ordinary skill in the field without creative work shall fall within the scope of the present disclosure.

In the description of the present disclosure, it should be noted that the orientation or positional relationship indicated by terms "center", "above", "under", "left", "right", "vertical", "horizontal", "inner", "outer", and the like are based on the orientation or positional relationship shown in the drawings, which is only for the convenience of describing the present disclosure and simplifying the description, rather than indicating or implying that the device or element referred to must have a specific orientation or be constructed and operated in a specific orientation, and thus it is not to be construed as a limitation of the present disclosure. In addition, the terms of "first", "second", and "third" are only used for descriptive purposes and cannot be understood as indicating or implying relative importance.

The present disclosure can be implemented in many different forms and should not be construed as being limited to the embodiments set forth herein. On the contrary, these embodiments are provided so that the present disclosure is thorough and complete, and the concept of the present disclosure is fully conveyed to those skilled in the art. The present disclosure is only defined by the claims. In the drawings, the sizes and relative sizes of layers and regions are exaggerated for clarity. It should be understood that when an element such as a layer, region, or substrate is referred to as being "formed on" or "disposed on" another element, the element may be directly disposed on another element, or there may be an intermediate element. In contrast, when an element is referred to as being "directly formed on" or "directly disposed on" another element, there is no intermediate element.

In addition, the technical features involved in the different embodiments of the present disclosure described below can be combined with each other as long as there is no conflict between them.

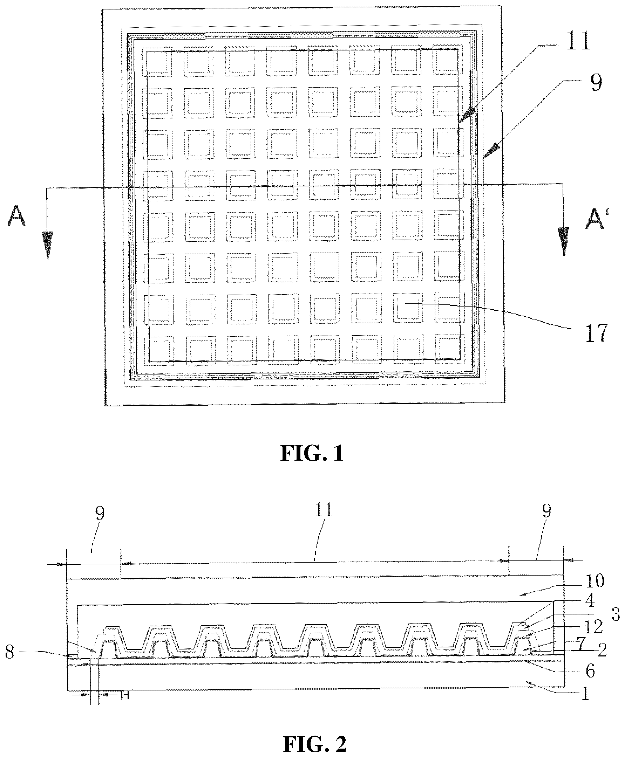

As shown in FIGS. 1 and 2, an OLED device provided by the present disclosure includes a substrate 1 and an encapsulation layer 10. The substrate 1 and the encapsulation layer 10 form a hermetic space in which a first electrode layer 2, an auxiliary electrode 7 and a pixel defining layer 12 are arranged. Abuffer layer 6 is provided between the first electrode layer and a substrate. The buffer layer 6 is provided with a number of auxiliary electrodes 7 arranged at intervals. The first electrode layer 2 covers the buffer layer 6 and the auxiliary electrode 7. The pixel defining layer 12 completely covers the first electrode layer 2 on the auxiliary electrode and is patterned with an aperture 17 which exposes at least a part of the first electrode layer 2. The shape of the aperture 17 is a trapezoidal structure. The bottom of the trapezoid is the first electrode layer 2. The pixel defining layer 12 and the aperture 17 are sequentially covered with an organic light-emitting layer 3, a second electrode layer 4 and a encapsulation layer 10.

The substrate 1 is divided with a number of pixel regions 11 and an encapsulation region surrounding all the pixel regions 11, an edge position of each pixel region 11 is surrounded by the pixel defining layer 12. The auxiliary electrodes are distributed in the horizontal position and/or vertical position of the pixel regions distributed in the array. The first electrode layer 2 and the auxiliary electrode 7 at a region between the auxiliary electrode 7 and the encapsulation region are removed by etching process so that the buffer layer is in direct contact with the pixel defining layer 12 located between the auxiliary electrode 7 and the encapsulation region. Preferably, the width of the region at which the pixel defining layer 12 is in direct contact with the buffer layer 6 is 5 µm to 10 mm.

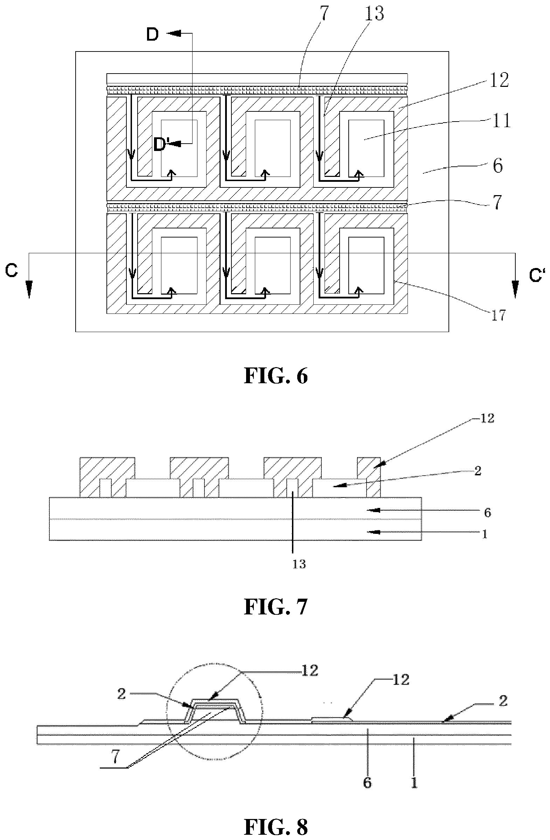

In a preferred embodiment, as shown in FIG. 6, the first electrode layer 2 located on one or two sides of the auxiliary electrode 7 is removed by etching process so that the pixel defining layer 12 located at this region is in direct contact with the buffer layer. The width of the region at which the first electrode layer 2 located on one or two sides of each auxiliary electrode 7 is in direct contact with the buffer layer 6 is 1 µm to 1 cm. The width of the region at which the pixel defining layer 12 is in direct contact with the buffer layer 6 located on one or two sides of each auxiliary electrode 7 is 5 µm to 10 mm.

The auxiliary electrode 7 is a combination of one or more of titanium (Ti), aluminum (Al), molybdenum (Mo), or copper (Cu). For example, titanium aluminum titanium (TiAlTi), aluminum titanium (AlTi), aluminum molybdenum (AlMo), molybdenum aluminum molybdenum (MoAlMo), molybdenum (Mo), titanium (Ti), copper (Cu) and aluminum (Al). As shown in the FIG. 3, the taper angle of the auxiliary electrode 7 is 10° to 90°, and the taper angle here refers to the taper angle of the aluminum layer in the auxiliary electrode 7.

The etching selection ratio of a material with a low etch rate of the auxiliary electrode 7 to a material of the buffer layer 6 is (0.5-20) and is preferably (5-7). The Ti or Mo material in the auxiliary electrode has a low etch rate.

The etching selection ratio of a material of the pixel defining layer 12 to the material of the buffer layer 6 is (0.5-5).

The thickness of the buffer layer 6 is 10 nm to 3 µm and is preferably100 nm.

A planarized auxiliary buffer layer is also provided on the buffer layer 6 located between the auxiliary electrodes 7, and the auxiliary electrode 7 is higher than the auxiliary buffer layer by 0 µm to 1 µm.

The pixel defining layer 12, the buffer layer 6 and the encapsulation layer are made of the same materials or different materials which are a combination of one or more of silicon nitride, silicon oxide, or silicon oxynitride.

The encapsulation layer 10 is a glass encapsulation cover 5 provided with the UV glue 8. The glass encapsulation cover 5 is combined with the buffer layer 6 and/or the pixel defining layer 12 on the substrate 1 through the UV glue 8.

Of course, the encapsulation layer may also adopt a thin film encapsulation method, and the encapsulation layer 10 may be made by chemical vapor deposition. The organic light-emitting layer 3, the second electrode layer 4, and the encapsulation layer are sequentially covered from bottom to top on the pixel defining layer 12 and in the aperture. Meanwhile, the encapsulation layer at the encapsulation region is in direct contact with the buffer layer to form thin-film encapsulation. An encapsulation transition layer such as the UV glue or OCA glue is attached to the encapsulation layer, and then a cover plate is attached to the encapsulation transition layer for sealing. Here the cover plate may include glass, copper foil, aluminum foil, and the like.

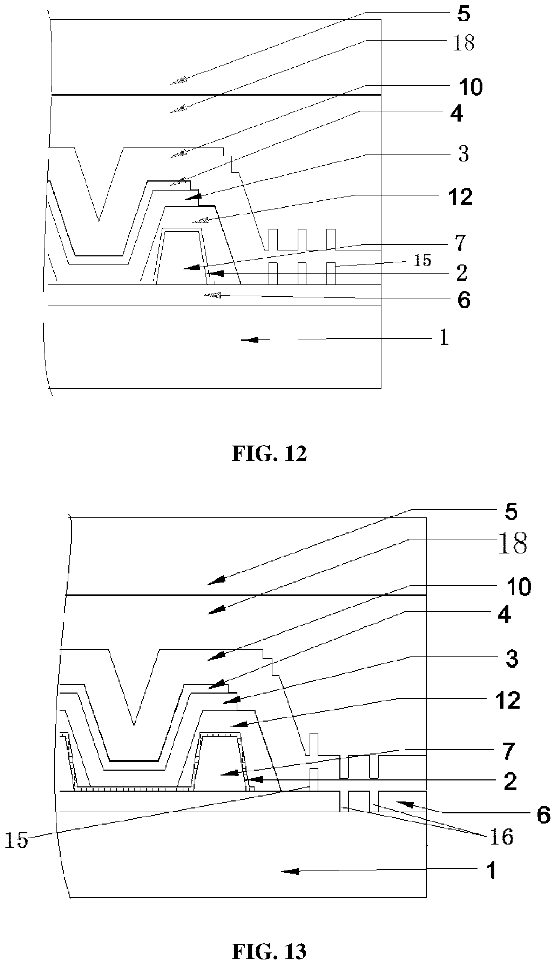

In order to achieve a better encapsulation effect at the OLED encapsulation region, a continuous patterned structure is formed on the buffer layer 6 located at the encapsulation region, and the encapsulation layer 10 is in direct contact with the patterned structure formed on the buffer layer 6. As shown in FIGS. 12, 13, and 14, the patterned structure here is a number of groove structures 16 and/or dam structures 15 patterned on the buffer layer 6. The encapsulation layer covers the patterned structure, and the encapsulation layer 10 is in direct contact with the patterned groove structure 16 and/or the dam structure 15 on the buffer layer 6, further forming a good stress relief structure, increasing the interface bonding encapsulation effect, reducing the intrusion of water and oxygen, and improving the encapsulation reliability.

As shown in FIG. 1 to FIG. 2, a manufacturing method of an OLED device includes the steps described below.

In S1, a substrate 1 is divided into a pixel region 11 and an encapsulation region surrounding the pixel region 11, a buffer layer 6 is deposited on the pixel region, an auxiliary electrode layer 7 is manufactured on the buffer layer 6 which is etched to form a number of auxiliary electrodes 7 arranged at intervals, and the taper angle of the auxiliary electrode 7 is 10° to 90°.

In S2, a first electrode layer 2 is manufactured on the basis of step S1. The first electrode layer 2 covers the buffer layer 6 and the auxiliary electrode 7. The first electrode layer 2 located between the auxiliary electrode 7 and the encapsulation region 9 is removed by etching process in order to expose the buffer layer 6.

In S3, a pixel defining layer 12 is deposited on the basis of step S2, where the pixel defining layer 12 covers the first electrode layer 2 and the buffer layer 6. The pixel defining layer 12 is etched to form an aperture of a trapezoidal structure. The bottom of the trapezoidal structure is the first electrode layer 2 and the buffer layer 6.

In S4, an organic light-emitting layer 3 and a second electrode layer 4 are made by an evaporation method on the basis of step S3, and the organic light-emitting layer 3 and the second electrode layer 4 are sequentially formed on the pixel defining layer 12 and the aperture.

In S5, an encapsulation layer 10 is made on the basis of step S4, the encapsulation layer 10 covers the entire pixel region 11, and the encapsulation region 9 surrounding the pixel region 11 seals and protects the entire pixel region 11.

When the structure shown in FIG. 6 to FIG. 9 is manufactured, the other steps are the same as above, where step S2 is as follows: the first electrode layer 2 is manufactured on the basis of step S1, the first electrode layer 2 covers the buffer layer 6 and the auxiliary electrode 7, and the first electrode layer 2 located on one or two sides of the auxiliary electrode 7 is removed by etching process to expose the buffer layer 6; and etching is performed to form a short-circuit prevention structure layer 13, where the short-circuit prevention structure layer 13 is located under the pixel defining layer and covered by the pixel defining layer.

**The materials and thickness of each layer are as described below.**

**Buffer layer:** The buffer layer is made of an inorganic material, such as silicon nitride, silicon oxide and silicon oxynitride. The deposition method of the film layer may be chemical vapor deposition (CVD) or atomic layer deposition (ALD). The buffer layer is preferably silicon nitride, with a thickness of 10 nm to 3 µm, and preferably 100 nm to 150 nm.

**Auxiliary electrode:** The auxiliary electrode is metal or metal alloy, such as titanium aluminum titanium (TiAlTi), aluminum titanium (AlTi), molybdenum aluminum (MoAl), molybdenum aluminum molybdenum (MoAlMo), Mo, Ti, Cu and Al. Dry etching process or wet etching process is used for patterning, and preferably a TiAlTi three-layer structure is used. The bottom of the structure is Ti with a thickness of 50 nm to 100 nm, preferably 75 nm; the top of the structure is Ti with a thickness of 50 nm to 100 nm, preferably 50 nm; the middle of the structure is Al with a thickness of 300 nm to 700 nm, preferably 300nm. C12 and BC13 (not limited to these two gases) are used for dry etching; the taper angle is 10° to 90°, and preferably 20° to 80°. The titanium aluminum (AlTi) structure is the Al material layer at the bottom and the Ti material layer at the top, as shown in FIG. 3. The molybdenum aluminum molybdenum (MoAlMo) structure is the Mo material layer, the Al material layer and the Mo material layer from the bottom to the top.

**First electrode layer:** The transparent conductive metal oxide, such as ITO and AZO, is sputtered by PVD; dry etching or wet etching is used for patterning, and wet etching is preferably used, for example, etching is performed with hydrochloric acid, nitric acid, acetic acid or a combination thereof. It is preferable to have the short-circuit prevention structure by patterning the first electrode to form the pixel, referring to FIG. 6.

**Pixel defining layer (or dielectric layer or insulating layer):** The pixel defining layer is located above the first electrode layer and/or the auxiliary electrode, is made of silicon oxide, silicon nitride or silicon oxynitride, uses the same process (such as CVD and ALD) as the buffer layer and has a thickness of 200 nm to 500 nm, preferably 300 nm. The etching selection ratio of the pixel defining layer to the buffer layer is 0.5-5. The process of "pixel" formation through patterning the first electrode can make the pixel defining layer in direct contact with the buffer layer, as shown in the figure where H ≥ 0.5 µm. Thus, the pixel defining layer forms a good surrounding structure for the OLED effective pixel region and/or pixel, which prevents the gases that can cause pixel shrinkage from being released (outgased) into the pixel, improving the reliability of the OLED panel. The materials of the pixel defining layer and the buffer layer are generally the same, so the interface bonding properties are more stable, so that the encapsulation reliability of the panel is further improved.

**Organic light-emitting layer 3:** The organic light-emitting layer 3 includes , but is not limited to, a hole injection layer (HIL), a hole transport layer (HTL), a light-emitting layer (EL), an electron transport layer (ETL), and an electron injection layer (EIL).

**Second electrode layer 4:** The second electrode layer 4 includes an Al electrode, an MgAg electrode, a metal oxide electrode (such as ITO), and the like. For example, a layer of Al with a thickness of 200 nm is sputtered by the thermal evaporation.

**Encapsulation layer 10:** The organic light-emitting layer 3 is encapsulated by combinations of a traditional glass encapsulation cover and the UV glue or frit. For example, the UV glue is used to encapsulate the substrate and the encapsulation cover to avoid water and oxygen corrosion.

Of course, in order to improve the encapsulation reliability of the panel, the thin film encapsulation method is used, such as inorganic layer/organic layer/inorganic layer. The inorganic layer can be deposited by chemical vapor deposition (CVD) so that thin film deposition is performed, and the organic layer can be printed by inkjet printing (IJP) so that thin film printing is performed. For example, SiO (1 µm) / IJP(8 µm) / SiO(1 µm) is used.

The present disclosure has the embodiments described below.

### Embodiment 1

As shown in FIG. 1 and FIG. 2, an OLED device provided by the present disclosure includes a substrate 1 and an encapsulation layer 10. The substrate 1 is divided into a pixel region 11 and an encapsulation region 9 surrounding the pixel region 11. The UV glue 8 located at the encapsulation region 9 seals and connects the substrate 1 and the encapsulation layer 10 to form a hermetic space. The encapsulation layer here is a glass encapsulation cover. A dry sheet can be provided on the side of the encapsulation cover facing towards the substrate 1 to absorb water vapor. The UV glue is used as a sealing material layer to encapsulate the substrate and the encapsulation cover, which can improve the encapsulation reliability of the panel. The thickness of the buffer layer 6 is 10 nm to 3 µm.

The light-emitting region of the substrate 1 is provided with the buffer layer 6, and a number of auxiliary electrodes 7 arranged at intervals are provided on the buffer layer 6. A first electrode layer 2 covers the buffer layer 6 and the auxiliary electrodes 7. The first electrode layer 2 located between the auxiliary electrodes 7 and the encapsulation region is removed by etching process to expose the buffer layer 6. The width of the removed first electrode layer 2 is H = 10 µm.

The pixel defining layer 12 completely covers the first electrode layer on the auxiliary electrode and is patterned with apertures which expose at least a part of the first electrode layer. The shape of the aperture is a trapezoidal structure. The bottom of the trapezoid is the first electrode layer 2. The organic light-emitting layer 3 and the second electrode layer 4 are sequentially formed on the pixel defining layer 12 and the apertures. The buffer layer 6 is in direct contact with the pixel defining layer 12 since no first electrode layer exists on the buffer layer 6 located between the auxiliary electrode 7 and the encapsulation region 9.

The width H of the region at which the pixel defining layer 12 is in direct contact with the buffer layer 6 is 10 µm.

The auxiliary electrode 7 includes an Al material layer and a Ti material layer which are superimposed. The Ti material layer is located above the Al material layer. As shown in FIG. 3, the taper angle of the auxiliary electrode 7 is 20° to 80°. It can be concluded from the comparison of FIG. 3 with FIG. 4 that adding a SiN buffer layer can effectively improve the taper angle of AlTi. This is because the etching selection ratio of Al to Ti is relatively large. The rate of etching Al is greater than the rate of etching Ti. The side etching will occur on the substrate side without SiN added, leading to the undercut phenomenon. At the same time, the added buffer layer prevents the metal ions of the glass substrate from penetrating into the ITO layer, avoiding electrochemical corrosion of the ITO and improving the stability of the OLED device.

The etching selection ratio of the material of the auxiliary electrode 7 to the material of the buffer layer 6 is (0.5 - 20) and is preferably (5-7).

The etching selection ratio of the material of the pixel defining layer 12 to the material of the buffer layer 6 is (0.5-5).

The etching selection ratio refers to the ratio of the etch rate of different films under the same condition. That is, the etch rate of film A is Eₐ, the etch rate of film B under the same condition is E_{b}, and the etching selection ratio at this time is S_{A/B} = Eₐ/E_{b}.

The pixel defining layer and the buffer layer are made of the same materials or different materials which are a combination of one or more of silicon nitride, silicon oxide, or silicon oxynitride.

As shown in FIG. 6 to FIG. 9, a manufacturing method of an OLED device includes the steps described below.

In S1, a substrate 1 is divided into a pixel region 11 and an encapsulation region surrounding the pixel region 11, a buffer layer 6 is deposited at the pixel region, an auxiliary electrode layer is manufactured on the buffer layer 6 which is etched to form a number of auxiliary electrodes 7 arranged at intervals, and the taper angle of the auxiliary electrode 7 is 20° to 80°.

In S2, a first electrode layer 2 is manufactured on the basis of step S1. The first electrode layer 2 covers the buffer layer 6 and the auxiliary electrode 7. The first electrode layer 2 located between the auxiliary electrodes 7 and the encapsulation region is removed by etching process in order to expose the buffer layer 6.

In S3, a pixel defining layer 12 is deposited on the basis of step S2, where the pixel defining layer 12 covers the first electrode layer 2 and the buffer layer 6 located between the auxiliary electrodes 7 and the encapsulation region. The pixel defining layer 12 is etched to form an aperture of a trapezoidal structure. The bottom of the trapezoidal structure is the first electrode layer 2 and the buffer layer.

In S4, an organic light-emitting layer 2 and a second electrode layer 3 are made by an evaporation method on the basis of step S3, where the organic light-emitting layer 3 and the second electrode layer 4 are sequentially formed on the pixel defining layer 12 and the aperture.

In S5, an encapsulation layer 10 is made on the basis of step S4, where the encapsulation layer 10 is a glass encapsulation cover. The UV glue is coated on the glass encapsulation cover which is then sealed and connected to the buffer layer at the position of the encapsulation region on the substrate, thereby achieving the encapsulation of the entire pixel region, as shown in FIG. 2.

**The materials and thicknesses of each layer in this embodiment are as described below.**

Substrate 1 is made of an alkali-free glass.

For the buffer layer 6 a layer of silicon nitride of 100 nm is deposited through high temperature CVD process, the temperature of the process is 350°C, the adhesion force to the substrate is 5B, and the refractive index is 1.8.

The auxiliary electrode 7 is AlTi, the top of the structure is Ti with a thickness of 50 nm, and the thickness of Al is 300 nm. The patterning by dry etching process is made through C12 and BC13, with a taper angle of 70°. Etching is not limited to dry etching, and the wet etching may also be used. A certain proportion of the mixed acid solution H3PO4, CH3COOH and HNO3 is used for etching.

For the first electrode layer 2, indiumtin oxide (ITO) is sputtered by PVD, with a thickness of 150 nm, and patterning is performed by wet (acid etching) process.

The pixel defining layer 12 located above the first electrode layer is made of SiN, adopts the same process as the buffer layer, and has a thickness of 300 nm. The grid size is 400 µm ^{∗} 400 µm. The pixel defining layer is patterned and formed by dry etching process.

**Organic light-emitting layer 3:** The organic light-emitting layer 3 includes, but is not limited to, a hole injection layer (HIL), a hole transport layer (HTL), a light-emitting layer (EL), an electron transport layer (ETL), and an electron injection layer (EIL).

**Second electrode layer 4:** The second electrode layer 4 includes an Al electrode, an MgAg electrode, and a metal oxide electrode (such as the ITO). For example, a layer of Al with a thickness of 200 nm is sputtered by the thermal evaporation.

**Encapsulation layer 10:** The organic light-emitting layer 3 is encapsulated by combinations of a traditional glass encapsulation cover and the UV glue or frit.

On the basis of Embodiment 1, different materials of the auxiliary electrode 7 and different materials of the buffer layer 6 are selected. Preferably, the etching selection ratio of the material of the pixel defining layer 12 to the material of the buffer layer 6 is 1.

The effects of different etching selection ratios of the auxiliary electrode to the buffer layer are shown in the following table:

| Etching selection ratio of the auxiliary electrode layer 7 to the buffer layer 6 | Taper of Al | Side etching of Al |
|---|---|---|
| < 0.5 | \ | With |
| 0.5 to 20 | 70 | Without |
| > 20 | \ | With |

It can be seen from the above table that when the etching selection ratio of the material of the auxiliary electrode 7 to the material of the buffer layer 6 is relatively small (< 0.5), the buffer layer is easy to be etched away, resulting in the side etching problem as shown in FIG. 4, so an inverted trapezoid shape appears. When the etching selection ratio is relatively high (> 20), the buffer layer is difficult to be etched away and also prone to side etching, and then an inverted trapezoid shape appears. In the present disclosure, the preferred etching selection ratio of the material of the auxiliary electrode 7 to the material of the buffer layer 6 is 5-7, and the taper angle of Al can be controlled at 70° ± 3°. At the same time, the material of the pixel defining layer 12 and the material of the buffer layer 6 are preferably the same or similar, which can well ensure the interface bonding effect and make the subsequent OLED film layers more continuous as well as have a better encapsulation effect and increase the service life of the OLED device.

### Embodiment 2

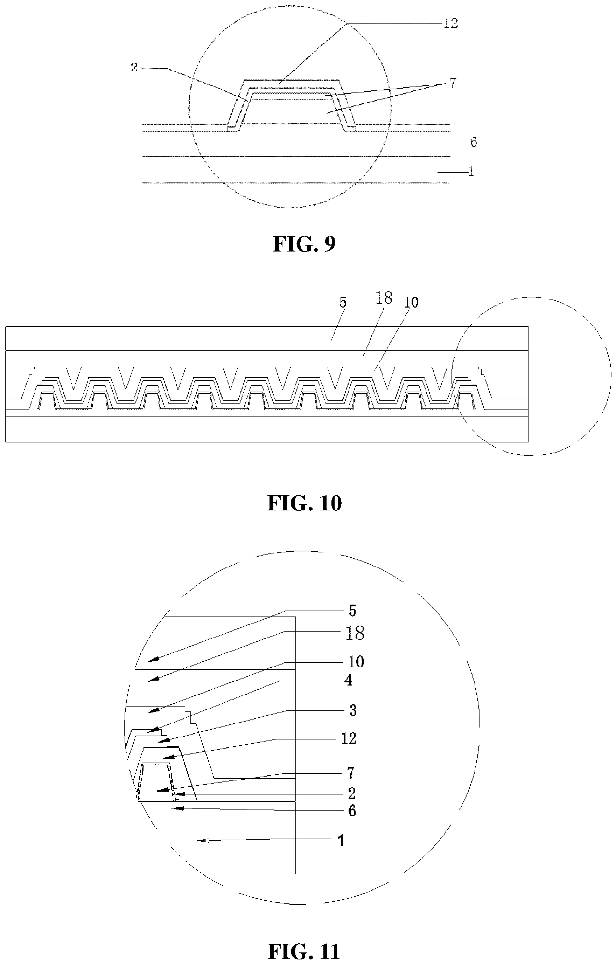

The basic structure of an OLED device provided by the present disclosure is the same as that of Embodiment 1, and the difference is that: the encapsulation layer in this embodiment adopts a thin film encapsulation structure, as shown in FIG. 10 and FIG. 11.

In S1, a substrate 1 is divided into a pixel region 11 and an encapsulation region surrounding the pixel region 11, a buffer layer 6 is deposited on the pixel region, an auxiliary electrode layer is manufactured on the buffer layer 6which is etched to form a number of auxiliary electrodes 7 arranged at intervals, and the taper angle of the auxiliary electrode 7 is 10°.

In S2, a first electrode layer 2 is manufactured on the basis of step S1, where the first electrode layer 2 covers the buffer layer 6 and the auxiliary electrode 7. The first electrode layer 2 located between the auxiliary electrodes 7 and the encapsulation region is removed by etching process in order to expose the buffer layer 6.

In S3, a pixel defining layer 12 is deposited on the basis of step S2, where the pixel defining layer 12 covers the first electrode layer 2 and the buffer layer 6 located between the auxiliary electrode 7 and the encapsulation region; the pixel defining layer 12 is etched to form an aperture of a trapezoidal structure, where the bottom of the trapezoidal structure is the first electrode layer 2 and the buffer layer.

In S4, an organic light-emitting layer 2 and a second electrode layer 3 are made by an evaporation method on the basis of step S3, and the organic light-emitting layer 3 and the second electrode layer 4 are sequentially formed on the pixel defining layer 12 and the aperture.

In S5, an encapsulation layer 10 is made on the basis of step S4, where the encapsulation layer 10 here adopts a thin film encapsulation method, such as inorganic layer/organic layer/inorganic layer. The inorganic layer can be deposited by chemical vapor deposition (CVD) so that thin film deposition is performed, and the organic layer can be printed by inkjet printing (IJP) so that thin film printing is performed. For example, SiO (1 µm) / IJP (8 µm) / SiO (1 µm) is used. The encapsulation layer 10 covers the entire pixel region 11, and the encapsulation region 9 surrounding the pixel region 11 seals and protects the entire pixel region 11.

In S6, an encapsulation transition layer 18 is coated on the cover plate 5, and then the cover plate 5 covers the encapsulation layer, thereby achieving encapsulation of the entire pixel region.

Compared with Embodiment 1, this embodiment adopts the film encapsulation method, which can further improve the encapsulation reliability of the panel.

### Embodiment 3

As shown in FIGS. 6 to 9, the basic structure of an OLED device provided by the present disclosure is the same as that of Embodiment 2, and the difference is as described below.

Alight-emitting region of the substrate 1 is provided with a buffer layer 6. The buffer layer 6 is provided with a short-circuit prevention structure layer 13 formed by the first electrode layer and with a number of auxiliary electrodes 7 arranged at intervals. A first electrode layer 2 covers the buffer layer 6 and the auxiliary electrode 7, the first electrode layer 2 located on one or two sides of the auxiliary electrode 7 is removed by etching process to expose the buffer layer 6, and the width of the removed first electrode layer 2 is H = 10 µm. A short-circuit prevention structure is introduced through the patterning of the first electrode, which can prevent the device from failure due to the short circuit of the device during the long-term aging (such as long-term lighting).

As shown in FIG. 7, a pixel defining layer 12 completely covers the first electrode layer 2 on the auxiliary electrode and is provided with apertures which expose at least a part of the first electrode layer 2, the shape of the aperture is a trapezoidal structure. The bottom of the trapezoid is the first electrode layer 2. The organic light-emitting layer 3 and the second electrode layer 4 are sequentially formed on the pixel defining layer 12 and on the aperture. Since no first electrode layer exists on the buffer layer located on one or two sides of the auxiliary electrode 7, the pixel defining layer 12 is in direct contact with the buffer layer 6 at this region.

Referring to FIG. 6 and FIG. 7, in the direction perpendicular to the auxiliary electrode, between two adjacent pixel regions distributed in an array, the first electrode layer is patterned with a short-circuit prevention structure layer 13, the short-circuit prevention structure layer 13 is electrically connected to the first electrode layer 2 on the auxiliary electrode 7 and one of the two adjacent pixel regions and forms a disconnect with another one of the two adjacent pixel regions. The pixel defining layer located on two sides of the short-circuit prevention structure layer 13 is in direct contact with the buffer layer 6. The current flow in each pixel region is shown by the arrow in FIG. 6.

The width of the region at which the pixel defining layer 12 is in direct contact with the buffer layer located on one or two sides of each auxiliary electrode is 10 µm.

A manufacturing method of an OLED device of this embodiment, as shown in FIG. 6, FIG. 7, FIG. 8, FIG. 9, and FIG. 11, includes the steps described below.

In S1, a substrate 1 is divided into a pixel region 11 and an encapsulation region surrounding the pixel region 11, a buffer layer 6 is deposited on the pixel region, an auxiliary electrode layer is manufactured on the buffer layer 6 which is etched to form a number of auxiliary electrodes 7 arranged at intervals, and the taper angle of the auxiliary electrode 7 is 70°.

In S2, a first electrode layer 2 is manufactured on the basis of step S1, where the first electrode layer 2 covers the buffer layer 6 and the auxiliary electrode 7. The first electrode layer 2 located on one or two sides of the auxiliary electrode 7 is etched in order to expose the buffer layer 6, and etching is performed to form the short-circuit prevention structure layer 13.

In S3, a pixel defining layer 12 is deposited on the basis of step S2, where the pixel defining layer 12 covers the first electrode layer 2 and the buffer layer 6 located between the auxiliary electrodes 7 and the encapsulation region. The pixel defining layer 12 is etched to form an aperture of a trapezoidal structure. The bottom of the trapezoidal structure is the first electrode layer 2 and the buffer layer.

In S4, an organic light-emitting layer 2 and a second electrode layer 3 are made by an evaporation method on the basis of step S3, and the organic light-emitting layer 3 and the second electrode layer 4 are sequentially formed on the pixel defining layer 12 and the aperture.

In S5, an encapsulation layer 10 is made on the basis of step S4, where the encapsulation layer 10 here adopts a thin film encapsulation method, such as inorganic layer/organic layer/inorganic layer. The inorganic layer can be deposited by chemical vapor deposition (CVD) so that thin film deposition is performed, and the organic layer can be printed by inkjet printing (IJP) so that thin film printing is performed. For example, SiO (1 µm) / IJP (8 µm) / SiO (1 µm) is used. The encapsulation layer 10 covers the entire pixel region 11, and the encapsulation region 9 surrounding the pixel region 11 seals and protects the entire pixel region 11.

In S6, an encapsulation transition layer 18 is coated on the cover plate 5, and then the cover plate 5 covers the encapsulation layer, thereby achieving the encapsulation of the entire pixel region.

### Embodiment 4

The basic structure of an OLED device provided by the present disclosure is the same as that of Embodiment 3, and the difference from Embodiment 3 is as described below.

As shown in FIG. 5, a following structure may also be formed on the substrate 1: A patterned auxiliary electrode 7 is formed on the substrate 1, and an auxiliary buffer layer 14 SiN (or SiOx) is formed on the buffer layer 6 between the auxiliary electrodes 7 by PECVD. The auxiliary buffer layer structure SiN (or SiOx) is planarized through methods such as dry etching, grinding or lift-off. It should be emphasized that the auxiliary electrode 7 needs to be higher than the auxiliary buffer layer 14 by a height D of 0 µm to 1 µm to facilitate the overlap of the first electrode layer. The buffer layer structure provided on the substrate used in Embodiments 1 to 3 is as shown in FIG. 3. In this embodiment, the grade climbing of the first electrode layer can be avoided. Although the overlap area of the first electrode layer on the auxiliary electrode is smaller than that of the structure shown in FIG. 3 in this embodiment, compared with Embodiment 1 and Embodiment 2, this embodiment will improve the uniformity of the overlap resistance.

### Comparative embodiment 1

A substrate 1 is made of an alkali-free glass and the conventional substrate structure shown in FIG. 4 is adopted.

An auxiliary electrode 7 is AlTi, the thickness of top titanium is 50 nm, and the thickness of the Al is 300 nm; the structure shown in FIG. 4 is manufactured by an etching method.

For a first electrode layer, indium tin oxide (ITO) is sputtered by PVD, with a thickness of 150 nm.

A pixel defining layer located above the first electrode layer is made of SiN, uses the same process as the buffer layer, and has a thickness of 300 nm; and the size of the grid is 400 µm ^{∗} 400 µm.

An organic light-emitting layer includes an HIL, an HTL, an EL, an ETL and an EIL.

A second electrode includes an Al electrode, and a layer of Al with a thickness of 200 nm is deposited by thermal evaporation.

An encapsulation layer is a glass encapsulation cover, and the encapsulation region of the substrate and the encapsulation cover are sealed by the UV glue to improve the encapsulation reliability of the panel.

### The experimental test results are as described below.

The service life test is performed at 1000 nits. It can be seen that for the device of the present disclosure, the service life of the OLED device can be increased by 5 times due to the addition of the buffer layer. It shows that adding a buffer layer can significantly improve the reliability of the panel. The main reasons are as described below.

Due to the existence of the buffer layer, the first electrode or the auxiliary electrode forms a more acute taper angle by dry etching process, that is, with the buffer layer disposed, the "undercut" phenomenon of the auxiliary electrode can be well improved, the occurrence of "side etching" can be avoided, and the taper angle of the auxiliary electrode can be better modified, thereby improving the overlap of the subsequent organic/metal/encapsulation film layers.

Furthermore, the added buffer layer can block the penetration of metal ions in the glass substrate into the first electrode layer/auxiliary electrode, avoid occurrence of electrochemical corrosion, and improve the stability of the OLED device.

After the test, the average service life of the device in Embodiment 1 is 500h@1000 nit, and the failure rate of the device at 1000 H under long-term aging is 20%.

The average service life of the device in Embodiment 2 is 550h @1000 nit, and the failure rate of the device at 1000 H under long-term aging is 10%.

The average service life of the device in Embodiment 3 is 560h@1000nit, and because of the addition of the short-circuit prevention structure, the device does not fail at 1000 H under long-term aging.

The average service life of the device in Embodiment 4 is 600h@1000nit, and because of the addition of the short-circuit prevention structure, the device does not fail at 1000 H under long-term aging.

The average service life of the device in Comparative embodiment 1 is 100h@1000 nit.

Through comparison, the embodiments 1 to 4 used in the present disclosure can greatly improve the life of the device compared with the existing art.

### Embodiment 5

In this embodiment, on the basis of Embodiment 3, the continuous dam structures surrounding the entire pixel region are provided at the buffer layer located in the encapsulation region, as shown in FIG. 12.

A manufacturing method of an OLED device includes the steps described below.

In S1, a substrate 1 is divided into a pixel region 11 and an encapsulation region surrounding the pixel region 11, a buffer layer 6 is deposited at the pixel region, an auxiliary electrode layer is manufactured on the buffer layer 6which is etched to form a number of auxiliary electrodes 7 arranged at intervals, and the taper angle of the auxiliary electrode 7 is 70°.

In S2, a first electrode layer 2 is manufactured on the basis of step S1. The first electrode layer 2 covers the buffer layer 6 and the auxiliary electrode 7. The first electrode layer 2 located on one or two sides of the auxiliary electrode 7 is removed by etching process in order to expose the buffer layer 6, and etching is performed to form the short-circuit prevention structure layer 13.

In S3, a pixel defining layer 12 is deposited on the basis of step S2, where the pixel defining layer 12 covers the first electrode layer 2 and the buffer layer 6 located at the encapsulation region. The pixel defining layer 12 is etched to form an aperture of a trapezoidal structure, **and a raised dam structure (DAM) is formed at the encapsulation region.**

In S4, an organic light-emitting layer 3 and a second electrode layer 4 are made by an evaporation method on the basis of step S3, and the organic light-emitting layer 3 and the second electrode layer 4 are sequentially formed on the pixel defining layer 12 and the aperture.

In S5, an encapsulation layer 10 is fabricated by chemical vapor deposition on the basis of step S4. The organic light-emitting layer 3, the second electrode layer 4 and an encapsulation layer are sequentially formed on the pixel defining layer 12 and the aperture. At the same time, the encapsulation layer at the encapsulation region is in direct contact with the buffer layer to form thin film encapsulation.

In S6, an encapsulation transition layer, such as the UV glue or OCA glue, is attached on the basis of step S5, and then a cover plate is attached to the encapsulation transition layer for sealing, where the cover plate may include glass, copper foil, aluminum foil, and the like.

### Embodiment 6

The difference from Embodiment 5 is that this embodiment uses a patterned structure on the buffer layer located at the encapsulation region. As shown in FIG. 13, the patterned structure surrounding all the pixel regions is provided with a continuous two groove structures, and a raised dam structure is also set on the inner side of the encapsulation region.

A manufacturing method of an OLED device includes the steps described below.

In S1, a substrate 1 is divided into a pixel region 11 and an encapsulation region surrounding the pixel region 11, a buffer layer 6 is deposited at the pixel region, and **the buffer layer 6 is patterned at the encapsulation region** to form two groove structures 16. An auxiliary electrode layer is manufactured on the buffer layer 6 which is etched to form a number of auxiliary electrodes 7 arranged at intervals, and the taper angle of the auxiliary electrode 7 is 70°.

In S2, a first electrode layer 2 is manufactured on the basis of step S1, where the first electrode layer 2 covers the buffer layer 6 and the auxiliary electrode 7. The first electrode layer 2 located on one or two sides of the auxiliary electrode 7 is removed by etching process in order to expose the buffer layer 6, and etching is performed to form the short-circuit prevention structure layer 13.

In S3, a pixel defining layer 12 is deposited on the basis of step S2, where the pixel defining layer 12 covers the first electrode layer 2 and the buffer layer 6 located at the encapsulation region. The pixel defining layer 12 is etched to form an aperture of a trapezoidal structure, **and a raised dam structure (DAM) is formed at the inner side of the encapsulation region.**

In S4, an organic light-emitting layer 2 and a second electrode layer 3 are made by an evaporation method on the basis of step S3, and the organic light-emitting layer 3 and the second electrode layer 4 are sequentially formed on the pixel defining layer 12 and the aperture.

In S5, an encapsulation layer 10 is fabricated by chemical vapor deposition on the basis of step S4. The organic light-emitting layer 3, the second electrode layer 4 and an encapsulation layer are sequentially formed on the pixel defining layer 12 and the aperture. At the same time, the encapsulation layer at the encapsulation region is in direct contact with the buffer layer to form thin film encapsulation.

In S6, an encapsulation transition layer, such as the UV glue or OCA glue, is attached on the basis of step S5, and then a cover plate is attached to the encapsulation transition layer for sealing, where the cover plate may include glass, copper foil, aluminum foil, and the like.

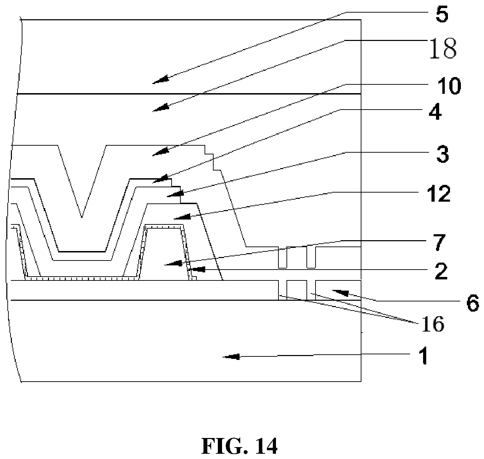

Of course, the patterned structure provided at the encapsulation region is not limited to the structures shown in FIG. 12 and FIG. 13, and the patterned groove structure may be provided merely in the encapsulation region, as shown in FIG. 14. Alternatively, the sequence is not limited to the combination sequence of the groove structure and the dam structure shown in FIG. 13, and the numbers of patterned groove structures and dam structures are not limited. Repetition is not made here.

### Comparative embodiment 2 (the comparative embodiment of Embodiment 5 and Embodiment 6)

A manufacturing method of an OLED device, as shown in FIG. 10 and FIG. 11, includes the steps described below.

In S1, a substrate 1 is divided into a pixel region 11 and an encapsulation region surrounding the pixel region 11, a buffer layer 6 is deposited at the pixel region, an auxiliary electrode layer is manufactured on the buffer layer 6 which is etched to form a number of auxiliary electrodes 7 arranged at intervals, and the taper angle of the auxiliary electrode 7 is 70°.

In S2, a first electrode layer 2 is manufactured on the basis of step S1, where the first electrode layer 2 covers the buffer layer 6 and the auxiliary electrode 7. The first electrode layer 2 located on one or two sides of the auxiliary electrode 7 is removed by etching process in order to expose the buffer layer 6, and etching is performed to form the short-circuit prevention structure layer 13.

In S3, a pixel defining layer 12 is deposited on the basis of step S2, where the pixel defining layer 12 covers the first electrode layer 2 and the buffer layer 6 located at the encapsulation region. The pixel defining layer 12 is etched to form an aperture of a trapezoidal structure.

In S4, an organic light-emitting layer 2 and a second electrode layer 3 are made by an evaporation method on the basis of step S3, and the organic light-emitting layer 3 and the second electrode layer 4 are sequentially formed on the pixel defining layer 12 and the aperture.

In S5, an encapsulation layer 10 is fabricated by chemical vapor deposition on the basis of step S4. The organic light-emitting layer 3, the second electrode layer 4 and an encapsulation layer are sequentially formed on the pixel defining layer 12 and the aperture. At the same time, the encapsulation layer at the encapsulation region is in direct contact with the buffer layer.

In S6, an encapsulation transition layer, such as the UV glue or OCA glue, is attached on the basis of step S5, and then a cover plate is attached to the encapsulation transition layer for sealing, where the cover plate may include glass, copper foil, aluminum foil, and the like.

After the test, the average service life of the device of Embodiment 5 of the present disclosure is 1000 h@1000 nit, the average service life of the device of Embodiment 6 is 1050 h@1000 nit, and the average service life of the device of Comparative embodiment 2 is 580 h@1000 nit. Therefore, the service life of the device is greatly improved.

Therefore, it is illustrated that the patterned buffer layer and pixel defining layer at the encapsulation region can greatly improve the service life of the device.

Apparently, the above-mentioned embodiments are merely examples for clear description and are not intended to limit the implementation. For those of ordinary skill in the art, other changes or modifications in different forms can be made on the basis of the above description. It is unnecessary and impossible to list all the implementations here. The apparent changes or modifications derived from this are still within the scope of the present disclosure.

## Claims

1. An organic light-emitting diode, OLED, device, comprising a substrate (1) and an encapsulation layer (10), wherein
the substrate (1) and the encapsulation layer (10) form a hermetic space in which a first electrode layer, serval auxiliary electrodes arranged at intervals and a pixel defining layer (12) are arranged;
a buffer layer (6) is provided between the first electrode layer/the serval auxiliary electrodes and the substrate (1),
the buffer layer (6) is provided with the serval auxiliary electrodes (7),
the first electrode layer (2) covers the buffer layer (6) and the serval auxiliary electrodes (7),
the pixel defining layer (12) completely covers the first electrode layer (2) on the auxiliary electrode (7) and is patterned with an aperture which exposes at least a part of the first electrode layer (2), and
the pixel defining layer (12) and the aperture are sequentially covered with an organic light-emitting layer (3) and a second electrode layer (4).

2. The OLED device according to claim 1, wherein the substrate (1) is divided with serval pixel regions (11) distributed in an array and an encapsulation region (9) surrounding all the pixel regions (11), an edge region of each of the serval pixel regions (11) is surrounded by the pixel defining layer (12), and
the serval auxiliary electrodes are distributed in at least one of a horizontal position or a vertical position of the pixel regions distributed in the array; and
the first electrode layer (2) and the serval auxiliary electrodes (7) at the encapsulation region (9) are removed by etching process so that the buffer layer (6) is in direct contact with the pixel defining layer (12).

3. The OLED device according to claim 1 or 2, wherein a continuous patterned structure is formed on the buffer layer (6) located at the encapsulation region, and the encapsulation layer (10) is in direct contact with the patterned structure formed on the buffer layer (6).

4. The OLED device according to claim 3, wherein the patterned structure is at least one of serval groove structures (16) or serval dam structures (15) patterned on the buffer layer (6).

5. The OLED device according to claim 4, wherein the first electrode layer (2) located on one or two sides of each of the serval auxiliary electrodes (7) is removed by etching process so that the pixel defining layer (12) located on the one or two sides of the each of the serval auxiliary electrodes (7) is in direct contact with the buffer layer (6).

6. The OLED device according to claim 5, wherein a width of a region at which the first electrode layer (2) located on one or two sides of the each of the serval auxiliary electrode (7) is in direct contact with the buffer layer (6) is 1 µm to 1 cm.

7. The OLED device according to claim 6, wherein the first electrode layer between two adjacent pixel regions distributed in the array is patterned with a short-circuit prevention structure layer (13) in a direction perpendicular to the serval auxiliary electrodes , and the short-circuit prevention structure layer (13) is electrically connected to the first electrode layer (2) on the each of the serval the auxiliary electrode (7) and one of the two adjacent pixel regions and forms a disconnect with another one of the two adjacent pixel regions; and the pixel defining layer located on two sides of the short-circuit prevention structure layer (13) is in direct contact with the buffer layer (6).

8. The OLED device according to claim 7, wherein a width of a region at which the pixel defining layer (12) is in direct contact with the buffer layer located on one or two sides of the each of the serval auxiliary electrodes (7) is 5 µm to 10 mm.

9. The OLED device according to claim 1, wherein each of the serval auxiliary electrodes (7) is a combination of one or more of titanium, Ti, aluminum, Al, molybdenum, Mo, or copper, Cu.

10. The OLED device according to claim 1, wherein a taper angle of each of the serval auxiliary electrodes (7) is 10° to 90°.

11. The OLED device according to claim 1, wherein an etching selection ratio of a material with a low etching rate of each of the serval auxiliary electrodes (7) to a material of the buffer layer (6) is (0.5-20); and the etching selection ratio of a material of the pixel defining layer (12) to the material of the buffer layer (6) is (0.5-5).

12. The OLED device according to claim 11, wherein an etching selection ratio of thematerial of each of the serval auxiliary electrode (7) to the material of the buffer layer (6) is (5-7).

13. The OLED device according to claim 1, wherein a thickness of the buffer layer (6) is 10 nm to 3 µm.

14. The OLED device according to claim 12, wherein a planarized auxiliary buffer layer (14) is also provided on the buffer layer (6) located between the serval auxiliary electrodes (7), and the each of the serval auxiliary electrodes (7) is higher than the auxiliary buffer layer (14) by 0 µm to 1 µm.

15. The OLED device according to claim 1, wherein the pixel defining layer (12), the buffer layer (6) and the encapsulation layer (10) are made of same materials or different materials which are a combination of one or more of silicon nitride, silicon oxide, or silicon oxynitride.

16. The OLED device according to claim 1, wherein the encapsulation layer (10) has a thin film encapsulation structure, a cover plate (5) is further provided on the encapsulation layer (10), and the cover plate (5) is combined with the encapsulation layer (10) through an encapsulation transition layer (18).

17. The OLED device according to claim 1, wherein the encapsulation layer (10) is an encapsulation cover, and the encapsulation cover is combined with the buffer layer (6) of an encapsulation region on the substrate (1) by an ultraviolet, UV, glue (8).

18. A manufacturing method of an OLED device, comprising the following steps:
S1: dividing a substrate (1), into a pixel region (11) and an encapsulation region surrounding the pixel region (11), and depositing a buffer layer (6) on the substrate, wherein an auxiliary electrode layer is manufactured on the buffer layer (6) which is etched to form serval auxiliary electrodes (7) arranged at intervals, and a taper angle of each of the serval auxiliary electrodes (7) is 10° to 90°;
S2: manufacturing a first electrode layer (2) on a basis of step S1, wherein the first electrode layer (2) covers the buffer layer (6) and the auxiliary electrode (7), and removing by etching process the first electrode layer (2) located between the auxiliary electrode (7) and the encapsulation region in order to expose the buffer layer (6);
S3: depositing a pixel defining layer (12) on a basis of step S2, wherein the pixel defining layer (12) covers the first electrode layer (2) and the buffer layer (6), and etching the pixel defining layer (12) to form an aperture, wherein a bottom of the aperture is the first electrode layer (2) and the buffer layer (6);
S4: making an organic light-emitting layer (3) and a second electrode layer (4) by an evaporation method on a basis of step S3, wherein the organic light-emitting layer (3) and the second electrode layer (4) are sequentially formed on the pixel defining layer (12) and the aperture; and
S5: making an encapsulation layer on a basis of step S4, wherein the encapsulation layer covers the entire pixel region (11) and the encapsulation region surrounding the pixel region (11) seals and protects the entire pixel region (11).

19. The manufacturing method of the OLED device according to claim 18, wherein the step S2 is: manufacturing the first electrode layer (2) on the basis of the step S1, wherein the first electrode layer (2) covers the buffer layer (6) and the serval auxiliary electrodes (7), removing by etching process the first electrode layer (2) located on one or two sides of each of the serval auxiliary electrodes (7) so as to expose the buffer layer (6), and performing etching to form a short-circuit prevention structure layer (13).

20. The manufacturing method of the OLED device according to claim 18, wherein the buffer layer (6) located at the encapsulation region is formed with at least one of serval patterned groove structures (16) or serval dam structures (15) in the step S3, and the encapsulation layer (10) is in direct contact with at least one of the serval patterned groove structures (16) or the serval dam structures (15) on the buffer layer (6) in an encapsulating process of step S5.
